# EUROPEAN PATENT SPECIFICATION

(11) **EP 1 168 706 B1**
(45) Date of publication and mention of the grant of the patent: **15.04.2009**
(21) Application number: 01401565.5
(22) Date of filing: 15.06.2001
(51) Int. Cl.: H04L 7/033, H04L 7/04, H04J 3/06

(54) **Method and circuit for aligning data flows in time division frames**
Verfahren und Schaltung zur Einphasung von Datenströmen in Zeitmultiplex-Rahmen
Méthode et circuit d'alignement de phase de flux de données multiplexé dans le temps

(30) Priority: 27.06.2000 IT TO200633
(43) Date of publication of application: 02.01.2002
(73) Proprietor: Alcatel Lucent, 75008 Paris (FR)
(72) Inventor: Traverso, Giovanni, 23807 Rovagnate (Lecco) (IT); Novati, Marco, 23807 Merate (Lecco) (IT); Razzetti, Luca, 20099 Sesto San Giovanni (Milano) (IT)
(74) Representative: Menzietti, Domenico

(56) References cited:
- US-A- 4 788 681
- US-A- 5 014 272

## Description

The present invention relates to a method for aligning data flows in time division frames.

Carrying out of digital communication systems often has to face a condition, wherein input data to a telecommunication network node have a determined nominal frequency, but are affected by phase modulations with respect to a reference signal, such as a clock signal, said modulations being due to various reasons, such as thermal drifts and/or other propagation problems on the transmitting means.

As a result, said phase modulations, which may arise at high frequency (jitter) or at low frequency (wander), generate reception bit errors.

Therefore, in order to avoid recognition errors, the phase of said input data has to be aligned, e.g. inside the node, to the phase of a reference clock signal having the same instantaneous frequency. A correct phase alignment is most significant in the case of time division frames.

In order to obtain the above phase alignment, delay locked loops, also known as DLL, are commonly employed.

Also DLL loops are based on feedback loops and essentially comprise a delay line, receiving at its input the signal to be aligned, i.e. in the specific case the data signal, and producing several output signals, which are delayed with respect to the signal to be aligned. A phase comparator will check the phase difference of the input data signal with respect to the reference signal, i.e. by way of example the clock signal, and consequently instruct a control logic contolling the delay time introduced by the delay line, selecting one of the various taps in the delay line.

Alternatively, DLL circuits may also be used in those systems where the delay of the single delay element of the line is feedback controlled, obtaining a behaviour similar to the Phase Locked Loops.

One problem associated to these circuits is that they are particularly expensive from a power consumption viewpoint, since they operate continuously during the whole data flow transit. The problem related to power consumption is particularly critical with the increasing input data frequency and number of channels for each device, such as in the case of a switch matrix device.

US 4,788,681 shows a circuit for detecting a frame alignment word in a received bit stream and for checking whether the bit stream is aligned with an internal frame clock.

It is the object of the present invention to solve the above drawbacks and provide a method for aligning data flows in time division frames, having a more efficient and improved performance with respect to existing solutions.

In this frame, it is the main object of the present invention to provide a method for aligning data flows in time division frames, which is suitable for use at high frequencies and having low energy consumption.

In order to achieve such aims, it is the object of the present invention to provide a method for aligning data flows in time division frames and/or a circuit for aligning high frequency data in time division frames, and/or a delay line, incorporating the features of the annexed claims, which form an integral part of the description herein.

Further objects, features and advantages of the present invention will become apparent from the following detailed description and annexed drawings, which are supplied by way of non limiting example, wherein:
- Fig. 1 shows a basic block diagram of a telecommunication network receiver implementing a method for aligning data flows in time division frames, according to the present invention;
- Fig. 2 shows a basic diagram of a phase alignment circuit implementing the method for aligning data flows in time division frames, according to the present invention.

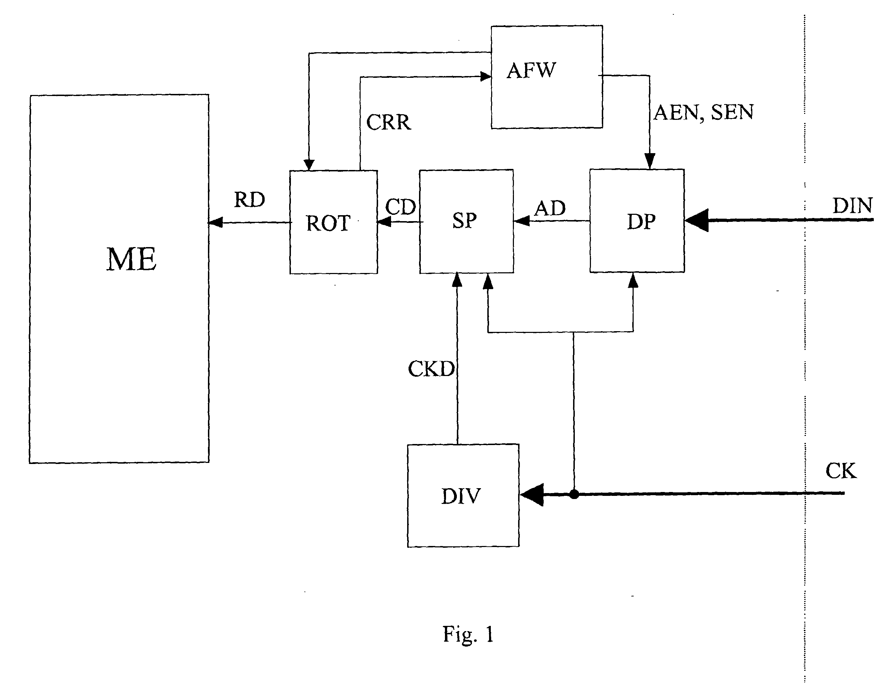

Figure 1 is representing a block diagram of the receiver of a "backpanel" like interface of a switching matrix in a synchronous telecommunication network, such as SDH (Synchronous Data Hierarchy); it is understood that the reference to SDH in the following has not to be interpreted in a limiting sense, as the invention can be applicable to SONET as well.

Figure 1 illustrates an input data flow DIN, which consists of an SDH frame flow at a nominal frequency of 622,08 MHz. Said data flow DIN is initially handled by a phase aligning circuit DP, which receives at another input the clock signal CK at 622,08 MHz, generated outside the interface of the switching matrix.

An aligned data flow AD output from the phase aligning circuit DP is now phase aligned with the clock signal CK and consequently sent to a serial-parallel circuit SP, which will perform a serial-to-parallel data conversion. The serial-parallel circuit SP is driven by a divided frequency clock signal CKD, generated by a special divider circuit DIV, which divides the clock signal CK by 8, originating a frequency of 77 MHz for the divided frequency clock signal CKD.

Therefore, the serial-parallel circuit SP produces a converted data flow CD, which is finally appropriately rotated by means of a rotator circuit ROT, controlled by a circuit for recognition of the alignment word AFW, usually placed on SDH frame receiving circuits, in order to align the bit flow correctly, identifying in SDH frames appropriate alignment words AW provided right to this purpose by the standards, i.e. recognition of information start point in the frame. The circuit for recognition of the alignment word AFW causes the byte to rotate inside the rotator circuit ROT for recovering the correct byte frame alignment, producing a rotated data flow output RD.

In the case of an input data flow DIN consisting of an STM-4 like frame, the alignment word AW matches the first 24 byte of the frame and consists of 12 byte representing the exadecimal value F6, followed by 12 byte representing the hexadecimal value 28. Since the hexadecimal value F6 matches a binary 11110110 and the hexadecimal value 28 matches a binary 00101000, the bit sequences 101 and 010, herein underlined inside the binary values for better highlighting them, well represent identifiable transitions in said byte.

The rotator circuit ROT sends to the circuit for recognition of the alignment word AFW an information on the correction CRR performed by said rotator circuit ROT, i.e. by how many bytes the word AW has been rotated to recover frame alignment. Since the byte structure F6 and 28 forming the alignment word AW is known, said information on the correction CRR also contains information about the transitions position and allows generating a synchronism, represented by a second enable signal SEN on the clock signal CK in correspondence with the sure transition on the input data flow DIN.

Since the information on the correction CRR comes from the rotator circuit ROT driven by the divided frequency clock signal CKD, it is clocked at 77 MHz frequency, but quite advantageously it also contains information about the bit of the alignment word AW, in spite of this alignment word AW being clocked at 622,08 MHz frequency.

Said rotated data flow RD is then received by an elastic memory ME, operating as a buffer, wherefrom it goes further to the remaining interface circuits.

In Figure 1 it should be noticed how according to a significant feature of the present invention, the circuit for recognition of the alignment word AFW also controls the phase aligning circuit DP. A portion of the logics required for phase alignment consists advantageously of the logic already provided for the circuit for recognition of the alignment word AFW, which performs frame alignment.

According to the present invention, the presence is used of a predetermined structure in time division frames , particularly in SDH frames, and also, specifically, the presence is used in said frames of the alignment word AW, which forms a sure data sequence containing a logic transition for measuring the phase displacement of the input data flow DIN with respect to the clock signal CK, just for a time interval matching the passage of said alignment word AW, maintaining said phase aligning circuit DP not in operation for the remaining passage of the frames contained in the data flow DIN.

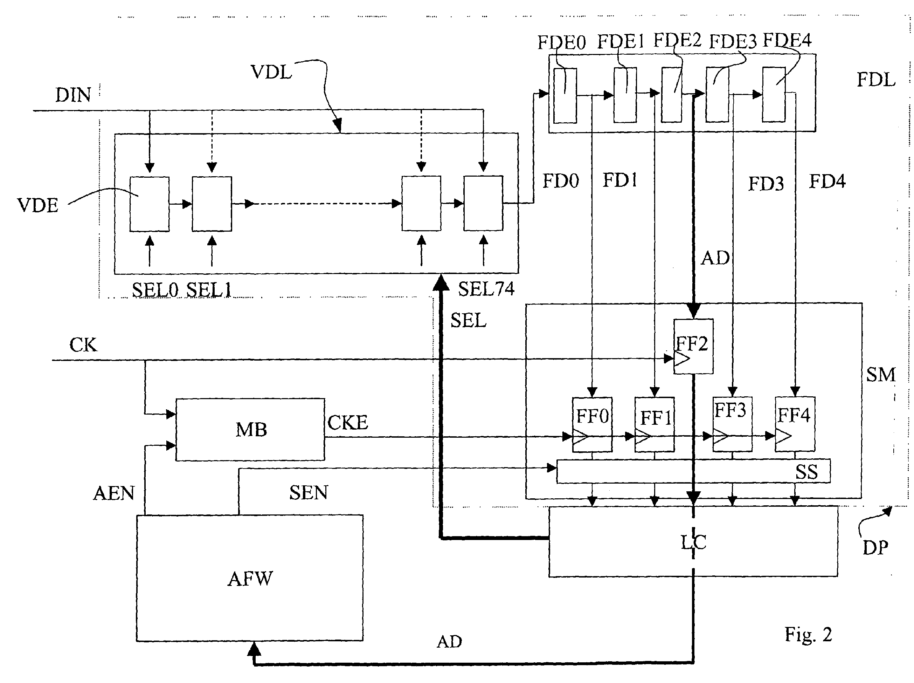

Figure 2 is representing a block diagram of the phase aligning circuit DP.

The input data flow DIN is sent to a variable delay line VDL pertaining to the phase aligning circuit DP, which counts 75 delay elements VDE, from VDE0 to VDE74, arranged in a ladder structure. Each delay element VDE is controlled by a respective selection signal SEL0...SEL74, whose effects on the elements VDE of the delay line VDL will be further explained. Downstream the variable delay line VDL, the input data flow reaches a fixed delay line FDL, which consists of five delay elements FDE with a fixed delay, i.e. from FDE0 to FDE4. Downstream of the element FDE2, which is the center element of the fixed delay line FDL, the aligned data flow AD is fetched and sent to the serial-parallel circuit SP, as illustrated in Figure 1. Therefore, this aligned data flow AD is sent to a flip-flop FF2, pertaining to a set of five flip-flops FF0 ... FF4, which form a monitoring line of a sampling and monitoring stage SM, together with a subsequent sampling stage SS consisting of two further five flip-flop stages masked by the second enable signal SEN, which enables them for operation, i.e. to let data advance only during the transit of the transition contained in the alignment word AW. Flip-flop FF2 is driven by the clock signal CK for governing the aligned data flow AD advance to the serial-parallel circuit SP, as well as to the circuit for recognition of the alignment word AFW.

Moreover, the clock signal CK is sent to a masking block MB, whose operation is controlled by the circuit for recognition of the alignment word AFW by means of an enable signal AEN for generating a masked clock signal CKE, i.e. a clock signal entirely similar to the clock signal CK for its frequency, but active only when the time window matches the passage of the alignment word AFW, i.e. being masked for the remaining frame transit time. This masked clock signal CKE drives the remaining flip-flops FF0, FF1, FF3, FF4 of the sampling and monitoring stage SM.

Downstream of each delay element FDE0, FDE1, FDE3, FDE4 of the fixed delay line FDL a phase shifted data flow FD0, FD1, FD3, FD4 is fetched and sent to the relevant flip-flop of the sampling and monitoring stage SM. From the flip-flops FF0, FF1, FF3 and FF4, the phase-shifted data flows FD0, FD1, FD3, FD4 will advance to a logic control circuit LC, along with the aligned data flow AD.

The logic control circuit LC - based on the phase-shifted data flows FD0, FD1, FD3, FD4 and aligned data flow AD - is apt to supply the selection signals SEL0 ... SEL74 for the variable delay line VDL.

The aligned data flow AD is also transmitted to the circuit for recognition of the alignment word AFW, in order to identify the alignment word AW.

The phase aligning circuit DP operates as follows: in stable conditions, i.e. without having to adjust the phase, the input data flow DIN goes through all elements VDE from a i-th delay element VDEi to VDE74, i.e. introducing a constant delay. This is obtained by the control logic LC placing the i-th selection signal SEL at logic level one and keeping all other selection signals SEL at logic level zero. In the practice, as it can be seen in Figure 2, the input data DIN go through the whole delay elements cascade VDE of the delay line VDL in a serial manner, accumulating the delay introduced by each delay element on the serial path, and are additionally sent in parallel to each delay element VDE, in this case without delay. When the signal SEL is a logic zero, the delay element is passing the data flow DIN, which receives in series. When the signal SEL is a logic one, the matching delay element VDE is not passing, so that the input data flow DIN received in parallel will propagate. In other words, all delay elements VDE upstream of the i-th non passing element VDE are by-passed and the delay introduced at the end of the serial track will only depend on the delay elements downstream the i-th delay element VDE, i.e. exactly the sum of said delays.

In other words, each delay element VDEi behaves like a multiplexer, letting either the input data flow DIN pass through, provided the respective selection signal SELi is one, or data come from the previous delay element VDE i-1, provided its own selection signal SELi is zero.

Should the control logic circuit LC detect a phase shift between the input data flow DIN and clock signal CK, and therefore a phase adjustment of the input data flow DIN be required, this control logic LC will move the index i of the signal SELi forward or backward by 1, i.e. setting the delay element VDE at logic one, which is either previous or subsequent to the one currently maintained at logic one, decrementing or incrementing the aligned data signal phase AD by one delay time. In order to avoid possible glitch phenomena, both the delay element VDEi and the subsequent selected element are simultaneously at logic one for a clock period of the divided frequency clock signal CKD. Changing the values of selection signals SEL is only admitted outside the time window, wherein the alignment word AW passes to the circuit for recognition of the alignment word AFW. Thus, possibly irrelevant samples eventually available on the flip-flops FF0, FF1, FF3, FF4 while changing the selection signals SEL do not determine the decision of the subsequent selection signals values SEL, because the subsequent time window on the alignment word AW must be waited.

The sampling and monitoring stage SM, driven by the second enable signal SEN, will activate in correspondence of the transitions 010 and 101 in the phase shifted data flows FD0, FD1, FD3, FD4 and aligned data flow AD, for controlling the input data phase DIN.

The circuit for recognition of the alignment word AFW sends the enable signal AEN to the masking block MB when the alignment word AFW is passing through it. Therefore, the sampling and monitoring stage SM allows the phase shifted data flows FD0, FD1, FD3, FD4 and aligned data AD to go to the control logic circuit LC for the 24-byte duration only of the alignment word AFW. This occurs because the masked clock signal CKE driving the first flip-flop stage FF0, FF1, FF3, FF4 of the sampling and monitoring stage SM is active during that time interval only. The subsequent stages of the sampling and monitoring stage SM, driven by the second enable signal SEN, will perform the sampling only in correspondence with the transitions 101 and 010 in the alignment word AW.

When the value sampled through the sampling and monitoring stage SM of the phase shifted data flows FD0, FD1, FD3, FD4 differs from the value of the aligned data flow AD, the control logic circuit LC operates a change of the selection signals SEL to modify the delay introduced by the variable delay line VDL. The criteria adopted by the control logic LC is as follows: it is enough,in at least one of the fetched 24 samples matching the 24 bytes that form the alignment word AW, that at least one of the phase shifted data flows FD0 and FD1, or one of the phase shifted data flows FD3 and FD4, differ from the aligned data flow AD, in order to decide whether incrementing or decrementing the index i of the selection signals SEL by one. In the above case, a change of said index is allowed for each frame, but said index may also be changed depending on the transit of a larger number of frames. Equally, the number of delay elements FDE of the fixed delay line FDL may be other than five. This odd number changes depending on the technologic spread.

From the above description the features of the present invention are clear, and also its advantages are clear.

Advantageously, the method for aligning data flows in time division frames according to the present invention allows to obtain a data phase alignment circuit operating efficiently at high frequency with an extremely reduced power consumption, since the phase alignment circuit will only operate during the passage of the frame alignment word, i.e. for the passage of a few bytes only, whereas said phase alignment circuit is deactivated during the passage of the remaining frame.

Advantageously, the phase alignment method of data flows in time division frames according to the present invention further utilizes digital delay lines, which ensure a high phase resolution and are driven by a control logic employing standard circuit elements .

Moreover, a delay line architecture is also advantageously described, which provides for changing the delay introduced without changing the delay of the individual cell and without fetching the data from the various delay line taps at the same time. This is an advantageous feature, since it avoids placing a complex multiplexer downstream of the delay line for the purpose of selecting the tap involved.

It is obvious that many changes are possible to the phase alignment of data flows in time division frames and/or to the phase alignment of an input data flow in a time division frame described in the above embodiment and it is also clear that in practical actuation of the invention the components may often differ in form and size from the ones described without departing from the scope of the invention as claimed. In particular, the forms of the data frames to which the method according to the present invention is applied to may differ and also the alignment sequences utilized for phase control may change and be differently arranged inside the frame.

## Claims

1. A method for aligning data flows in time division frames, that provides for measuring the phase of said input data flow (DIN) with respect to the phase of a reference signal (CK), for controlling the delay time introduced by a delay line (VDL) in said input data flow (DIN) depending on the measured phase, **characterized in that** the phase of the input data flow (DIN) is measured in a time interval substantially corresponding to the transit time of a sure data sequence containing a logic transition (AW), said sure data sequence (AW) being comprised in said input data flow (DIN).

2. A method for aligning data flows in time division frames, according to claim 1, **characterized in that** the flow of said sure data sequence containing a logic transition (AW) is detected, and consequently an enable signal (AEN) activating a phase sampling operation is generated.

3. A method for aligning data flows in time division frames, according to claim 2, **characterized in that**, by said enable signal (AEN), a masked reference signal (CKE) is obtained from the reference signal (CK), said masked reference signal (CKE) being active only during the passage of the sure data sequence containing a logic transition (AW).

4. A method for aligning data flows in time division frames, according to one of the previous claims 1 to 3, **characterized in that** a further delay line (FDL) is provided with a fixed delay for producing a plurality of delayed phases (FD0, FD1, AD, FD3, FD4) from the input data flow (DIN)

5. A method for aligning data flows in time division frames, according to claim 4, **characterized in that** said masked reference signal (CKE) is used for controlling execution of the sampling operation of said plurality of delayed phases (FD0, FD1, AD, FD3, FD4).

6. A method for aligning data flows in time division frames, according to claim 5, **characterized in that** a second enable signal (SEN) is obtained indicating the presence of the logic transition in the sure data sequence containing a logic transition (AW), and said second enable signal (SEN) is used for activating the sampling operation of said plurality of delayed phases (FD0, FD1, AD, FD3, FD4).

7. A method for aligning data flows in time division frames, according to claim 6, **characterized in that** said second enable signal (SEN) is obtained from a correction signal (CRR) deriving from an alignment operation of the input data flow (DIN)

8. A method for aligning data flows in time division frames, according to at least one of the claims from 2 to 7, **characterized in that** the result of said sampling operation is supplied to a control logic (LC), which generates selection signals (SEL0,.., SEL 74) apt for controlling the delay time of the delay line (VDL), depending on the said result of the sampling operation.

9. A method for aligning data flows in time division frames, according to claim 8, **characterized in that** the control logic (LC) decides for incrementing or decrementing by one the index i of the selection signals (SEL0 ... SEL 74), provided at least one of the first two delayed phases (FD0, FD1) or one of the last two delayed phases (FD3, FD4) in at least one of the values sampled during the whole transit of the sure sequence (AW), differs from an aligned data flow (AD).

10. A method for aligning data flows in time division frames, according to any of the previous claims, **characterized in that** said sure data sequence (AW) is a frame alignment word and that the time division frames forming the input data flow (DIN) are SDH or Sonet frames.

11. A phase alignment circuit of an input data flow in a time division frame, comprising phase equalizing means (SM, LC, FDL) apt to equalize the phase of a reference signal (CK) with the phase of the input data flow (DIN) and drive, through appropriate selection signals (SEL0..SEL74), a variable delay line (VDL) operating on the input data flow (DIN), **characterized in that** it provides detecting means (AFW, ROT) of the transit of a sure data sequence containing a logic transition (AW) comprised in the input data flow (DIN).

12. A phase alignment circuit of an input data flow in a time division frame, according to claim 11, **characterized in that** said detecting means (AFW, ROT) control operation of the phase equalizing means (SM, LC, FDL) through an enable signal (AEN).

13. A phase alignment circuit of an input data flow in a time division frame, according to claim 12, **characterized in that** logic masking means (MB) are provided apt to obtain a masked clock signal (CKE) from the combination of the enable signal (AEN) and reference signal (CK).

14. A phase alignment circuit of an input data flow in a time division frame, according to one of the claims from 11 to 13, **characterized in that**, downstream of the variable delay line (VDL), a further delay line (FDL) is provided pertaining to the phase equalizing means (SM, LC, FDL), which produces a plurality of delayed phases (FD0, FD1, AD, FD3, FD4) from the input data flow (DIN).

15. A phase alignment circuit of an input data flow in a time division frame, according to claim 14, **characterized in that** the phase equalizing means (SM, LC, FDL) comprise sampling means (SM) of said plurality of delayed phases (FD0, FD1, AD, FD3, FD4), which employ the masked clock signal (CKE) as a clock signal.

16. A phase alignment circuit of an input data flow in a time division frame, according to claim 15, **characterized in that** said sampling means (SM) of said delayed phase plurality (FD0, FD1, AD, FD3, FD4) receive at least a second enable signal (SEN) generated by the detecting means (AFW, ROT), which indicates the transit of the transition in the sure data sequence (AW).

17. A phase alignment circuit of an input data flow in a time division frame, according to claim 15 or 16, **characterized in that** the phase equalizing means (SM, LC, FDL) comprise control logic means (LC) arranged downstream the sampling means (SM), for receiving the sampled values of the plurality of delayed phases (FD0, FD1, AD, FD3, FD4) and emitting the selection signals (SEL0...SEL74) in function of them.

18. A phase alignment circuit of an input data flow in a time division frame, according to one of the claims from 10 to 16, **characterized in that** the variable delay line (VDL) is obtained through a ladder of delay elements (VDE).

19. A phase alignment circuit according to claim 11, wherein the delay line (VDL) comprises a plurality of delay elements (VDE), wherein the input data flow (DIN) passes in series through said plurality of delay elements (VDE), **characterized in that** one or more of the delay elements (VDE) also receive the input data flow (DIN) in parallel, and that said delay elements (VDE) are apt to select which of the data flows (DIN) received in series or in parallel should be transmitted.

## Patentansprüche

1. Ein Verfahren zur Einphasung von Datenströmen In Zeitmultiplex-Rahmen, welches die Messung der Phase des besagten Eingangsdatenstroms (DIN) in Bezug auf die Phase eines Referenzsignals (CK) bereitstellt, zur Steuerung der Verzögerungszeit, welche je nach der gemessenen Phase durch eine Verzögerungsleitung (VDL) in den besagten Eingangsdatenstrom (DIN) eingebracht wird, **dadurch gekennzeichnet, dass** die Phase des Eingangsdatenstroms (DIN) in einem Zeitabstand gemessen wird, welcher im Wesentlichen der Laufzeit einer zuverlässigen Datenfolge mit einem logischen Übergang (AW) entspricht, wobei die zuverlässige Datenfolge (AW) in dem besagten Eingangsdatenstrom (DIN) enthalten ist.

2. Ein Verfahren zur Einphasung von Datenströmen in Zeitmultiplex-Rahmen nach Anspruch 1, **dadurch gekennzeichnet, dass** der Strom der besagten zuverlässigen Datenfolge, welche einen logischen Übergang (AW) enthält, erfasst und anschließend ein Freigabesignal (AEN), welches einen Phasenabtastvorgang aktiviert, erzeugt wird.

3. Ein Verfahren zur Einphasung von Datenströmen in Zeitmultiplex-Rahmen nach Anspruch 2, **dadurch gekennzeichnet, dass** durch das besagte Freigabesignal (AEN) ein maskiertes Referenzsignal (CKE) aus dem Referenzsignal (CK) erhalten wird, wobei das besagte maskierte Referenzsignal (CKE) nur während des Durchlaufs der zuverlässigen Datenfolge, welche einen logischen Übergang (AW) enthält, aktiv ist.

4. Ein Verfahren zur Einphasung von Datenströmen in Zeitmultiplex-Rahmen nach einem der vorstehenden Ansprüche 1 bis 3, **dadurch gekennzeichnet, dass** eine weitere Verzögerungsleitung (FDL) mit einer fest eingestellten Verzögerung zum Erzeugen einer Vielzahl von verzögerten Phasen (FD0, FD1, AD, FD3, FD4) aus dem Eingangsdatenstrom (DIN) bereitgestellt wird.

5. Ein Verfahren zur Einphasung von Datenströmen in Zeitmultiplex-Rahmen nach Anspruch 4, **dadurch gekennzeichnet, dass** das besagte maskierte Referenzsignal (CKE) zum Steuern der Ausführung des Abtastvorgangs der besagten Vielzahl von verzögerten Phasen (FD0, FD1, AD, FD3, FD4) verwendet wird.

6. Ein Verfahren zur Einphasung von Datenströmen in Zeitmultiplex-Rahmen nach Anspruch 5, **dadurch gekennzeichnet, dass** ein zweites Freigabesignal (SEN) erhalten wird, welches das Vorhandensein des logischen Übergangs in der zuverlässigen Datenfolge, welche einen logischen Übergang (AW) enthält, anzeigt, und dass das besagte zweite Freigabesignal (SEN) zum Aktivieren des Abtastvorgangs der Vielzahl von verzögerten Phasen (FD0, FD1, AD, FD3, FD4) verwendet wird.

7. Ein Verfahren zur Einphasung von Datenströmen in Zeitmultiplex-Rahmen nach Anspruch 6, **dadurch gekennzeichnet, dass** das besagte zweite Freigabesignal (SEN) aus einem Korrektursignal (CRR), welches von einem Einphasungsvorgang des besagten Eingangsdatenstroms (DIN) hergeleitet wird, erhalten wird.

8. Ein Verfahren zur Einphasung von Datenströmen in Zeitmultiplex-Rahmen nach mindestens einem der Ansprüche 2 bis 7, **dadurch gekennzeichnet, dass** das Ergebnis des besagten Abtastvorgangs an eine Steuerlogik (LC) geliefert wird, welche Auswahlsignale (SEL0, ..., SEL 74) erzeugt, die fähig sind, die Verzögerungszeit der Verzögerungsleitung (VDL) entsprechend dem besagten Ergebnis des Abtastvorgangs zu steuern.

9. Ein Verfahren zur Einphasung von Datenströmen in Zeitmultiplex-Rahmen nach Anspruch 8, **dadurch gekennzeichnet, dass** die Steuerlogik (LC) darüber entscheidet, ob der Index i der Auswahlsignale (SEL0, ..., SEL 74) um eins erhöht oder gesenkt werden soll, vorausgesetzt, dass mindestens eine der ersten zwei verzögerten Phasen (FD0, FD1) oder eine der letzten zwei verzögerten Phasen (FD3, FD4) in mindestens einem der Werte, welche während des gesamten Transits der zuverlässigen Folge abgetastet werden, von einem eingephasten Datenstrom (AD) abweicht.

10. Ein Verfahren zur Einphasung von Datenströmen in Zeitmultiplex-Rahmen nach einem beliebigen der vorstehenden Ansprüche, **dadurch gekennzeichnet, dass** die besagte zuverlässige Datenfolge (AW) ein Rahmenwort ist, und dass die den Eingangsdatenstrom (DIN) bildenden Zeitmultiplex-Rahmen SDH- oder Sonet-Rahmen sind.

11. Eine Einphasungsschaltung eines Eingangsdatenstroms in einem Zeitmultiplex-Rahmen, welche Phasenentzerrungsmittel (SM, LC, FDL) umfasst, die fähig sind, die Phase eines Referenzsignals (CK) mit der Phase des Eingangsdatenstroms (DIN) zu entzerren und durch entsprechende Auswahlsignale (SELO..SEL74) eine variable Verzögerungsleitung (VDL), welche auf dem Eingangsdatenstrom (DIN) arbeitet, anzusteuern, **dadurch gekennzeichnet, dass** sie Detektormittel (AFW, ROT) für den Transit einer zuverlässigen Datenfolge, welche einen logischen Übergang (AW) umfasst, der in dem Eingangsdatenstrom (DIN) enthalten ist, bereitstellt.

12. Eine Einphasungsschaltung eines Eingangsdatenstroms In einem Zeitmultiplex-Rahmen nach Anspruch 11, **dadurch gekennzeichnet, dass** die besagten Detektormittel (AFW, ROT) anhand eines Freigabesignals (AEN) den Betrieb des Phasenentzerrungsmittels (SM, LC, FDL) steuern.

13. Eine Einphasungsschaltung eines Eingangsdatenstroms in einem Zeitmultiplex-Rahmen nach Anspruch 12, **dadurch gekennzeichnet, dass** logische Maskierungsmittel (MB) bereitgestellt werden, welche fähig sind, ein maskiertes Taktsignal (CKE) aus der Kombination des Freigabesignals (AEN) und des Referenzsignals (CK) zu erhalten.

14. Eine Einphasungsschaltung eines Eingangsdatenstroms in einem Zeitmultiplex-Rahmen nach einem der Ansprüche 11 bis 13, **dadurch gekennzeichnet, dass** der variablen Verzögerungsleitung (VDL) eine weitere die Phasenentzerrungsmittel (SM, LC, FDL) betreffende Verzögerungsleitung (FDL) nachgeordnet ist, welche eine Vielzahl von verzögerten Phasen (FD0, FD1, AD, FD3, FD4) aus dem Eingangsdatenstrom (DIN) erzeugt.

15. Eine Einphasungsschaltung eines Eingangsdatenstroms in einem Zeitmultiplex-Rahmen nach Anspruch 14, **dadurch gekennzeichnet, dass** die Phasenentzerrungsmittel (SM, LC, FDL) Abtastmittel (SM) der besagten Vielzahl von verzögerten Phasen (FD0, FD1, AD, FD3, FD4), welche das maskierte Taktsignal (CKE) als ein Taktsignal verwenden, umfasst.

16. Eine Einphasungsschaltung eines Eingangsdatenstroms in einem Zeitmultiplex-Rahmen nach Anspruch 15, **dadurch gekennzeichnet, dass** die besagten Abtastmittel (SM) der besagten Vielzahl von verzögerten Phasen (FD0, FD1, AD, FD3, FD4) mindestens ein zweites Freigabesignal (SEN) empfangen, welches von den Detektormitteln (AFW, ROT) erzeugt wird und den Transit des Übergangs in der zuverlässigen Datenfolge (AW) anzeigt.

17. Eine Einphasungsschaltung eines Eingangsdatenstroms in einem Zeitmultiplex-Rahmen nach Anspruch 15 oder 16, **dadurch gekennzeichnet, dass** die besagten Phasenentzerrungsmittel (SM, LC, FDL) Steuerlogikmittel (LC) umfassen, welche den Abtastmitteln (SM) nachgeschaltet sind, um die abgetasteten Werte der Vielzahl von verzögerten Phasen (FD0, FD1, AD, FD3, FD4) zu empfangen und in Abhängigkeit davon die Auswahlsignale (SELO...SEL74) zu senden.

18. Eine Einphasungsschaltung eines Eingangsdatenstroms in einem Zeitmultiplex-Rahmen nach einem der Ansprüche 10 bis 16, **dadurch gekennzeichnet, dass** die variable Verzögerungsleitung (VDL) über eine Kette von Verzögerungsgliedern (VDE) erhalten wird.

19. Eine Einphasungsschaltung nach Anspruch 11, wobei die Verzögerungsleitung (VDL) eine Vielzahl von Verzögerungsgliedern (VDE) umfasst, wobei der Eingangsdatenstrom (DIN) die besagte Vielzahl von Verzögerungsgliedern (VDE) seriell durchläuft, **dadurch gekennzeichnet, dass** eines oder mehrere der Verzögerungsglieder (VDE) den Eingangsdatenstrom (DIN) ebenfalls parallel empfangen, und dass die besagten Verzögerungsglieder (VDE) fähig sind, auszuwählen, ob die seriell oder die parallel empfangenen Datenströme (DIN) übertragen werden sollen.

## Revendications

1. Procédé pour aligner des flux de données dans des trames à répartition dans le temps, qui permet de mesurer la phase dudit flux de données d'entrée (DIN) par rapport à la phase d'un signal de référence (CK), pour commander le temps de retard introduit par une ligne à retard (VDL) dans ledit flux de données d'entrée (DIN) en fonction de la phase mesurée, **caractérisé en ce que** la phase du flux de données d'entrée (DIN) est mesurée dans un intervalle de temps correspondant sensiblement au temps de transit d'une séquence de données sûre contenant une transition logique (AW), ladite séquence de données sûre (AW) étant comprise dans ledit flux de données d'entrée (DIN).

2. Procédé pour aligner des flux de données dans des trames à répartition dans le temps, selon la revendication 1, **caractérisé en ce que** le flux de ladite séquence de données sûre contenant une transition logique (AW) est détecté et qu'en conséquence un signal d'activation (AEN) activant une opération d'échantillonnage de phase est généré.

3. Procédé pour aligner des flux de données dans des trames à répartition dans le temps, selon la revendication 2, **caractérisé en ce que**, par ledit signal d'activation (AEN), un signal de référence masqué (CKE) est obtenu à partir du signal de référence (CK), ledit signal de référence masqué (CKE) n'étant actif que pendant le passage de la séquence de données sûre contenant une transition logique (AW).

4. Procédé pour aligner des flux de données dans des trames à répartition dans le temps, selon l'une des revendications précédentes 1 à 3, **caractérisé en ce qu'**une autre ligne à retard (FDL) est dotée d'un retard fixe pour produire une pluralité de phases retardées (FDO, FD1, AD, FD3, FD4) à partir du flux de données d'entrée (DIN)

5. Procédé pour aligner des flux de données dans des trames à répartition dans le temps, selon la revendication 4, **caractérisé en ce que** ledit signal de référence masqué (CKE) est utilisé pour commander l'exécution de l'opération d'échantillonnage de ladite pluralité de phases retardées (FD0, FD1, AD, FD3, FD4).

6. Procédé pour aligner des flux de données dans des trames à répartition dans le temps, selon la revendication 5, **caractérisé en ce qu'**un deuxième signal d'activation (SEN) est obtenu, indiquant la présence de la transition logique dans la séquence de données sûre contenant une transition logique (AW), et **en ce que** ledit deuxième signal d'activation (SEN) est utilisé pour activer l'opération d'échantillonnage de ladite pluralité de phases retardées (FD0, FD1, AD, FD3, FD4).

7. Procédé pour aligner des flux de données dans des trames à répartition dans le temps, selon la revendication 6, **caractérisé en ce que** ledit deuxième signal d'activation (SEN) est obtenu à partir d'un signal de correction (CRR) dérivant d'une opération d'alignement du flux de données d'entrée (DIN).

8. Procédé pour aligner des flux de données dans des trames à répartition dans le temps, selon au moins une des revendications 2 à 7, **caractérisé en ce que** le résultat de ladite opération d'échantillonnage est fourni à une logique de commande (LC), qui génère des signaux de sélection (SEL0,.., SEL74) aptes à commander le temps de retard de la ligne à retard (VDL), en fonction dudit résultat de l'opération d'échantillonnage.

9. Procédé pour aligner des flux de données dans des trames à répartition dans le temps, selon la revendication 8, **caractérisé en ce que** la logique de commande (LC) décide d'incrémenter ou de décrémenter d'une unité l'indice i des signaux de sélection (SELO, ..., SEL74), à condition qu'au moins une des deux premières phases retardées (FD0, FD1) ou une des deux dernières phases retardées (FD3, FD4) d'au moins une des valeurs échantillonnées pendant le transit complet de la séquence sûre (AW) diffère d'un flux de données aligné (AD).

10. Procédé pour aligner des flux de données dans des trames à répartition dans le temps, selon l'une quelconque des revendications précédentes, **caractérisé en ce que** ladite séquence de données sûre (AW) est un mot d'alignement de trame et que les trames à répartition dans le temps formant le flux de données d'entrée (DIN) sont des trames SDH ou Sonet.

11. Circuit d'alignement de phase d'un flux de données d'entrée d'une trame à répartition dans le temps, comprenant des moyens d'égalisation de phase (SM, LC, FDL) aptes à égaliser la phase d'un signal de référence (CK) avec la phase du flux de données d'entrée (DIN) et commander, au moyen des signaux de sélection appropriés (SELO, ..., SEL74), une ligne à retard variable (VDL) fonctionnant sur le flux de données d'entrée (DIN), **caractérisé en ce qu'**il fournit des moyens de détection (AFW, ROT) du transit d'une séquence de données sûre contenant une transition logique (AW) comprise dans le flux de données d'entrée (DIN).

12. Circuit d'alignement de phase d'un flux de données d'entrée d'une trame à répartition dans le temps, selon la revendication 11, **caractérisé en ce que** lesdits moyens de détection (AFW, ROT) commandent le fonctionnement des moyens d'égalisation de phase (SM, LC, FOL) à l'aide d'un signal d'activation (AEN).

13. Circuit d'alignement de phase d'un flux de données d'entrée d'une trame à répartition dans le temps, selon la revendication 12, **caractérisé en ce que** des moyens de masquage logique (MB) sont fournis, aptes à obtenir un signal d'horloge masqué (CKE) à partir de la combinaison du signal d'activation (AEN) et du signal de référence (CK).

14. Circuit d'alignement de phase d'un flux de données d'entrée d'une trame à répartition dans le temps, selon l'une quelconque des revendications 11 à 13, **caractérisé en ce que**, en aval de la ligne à retard variable (VDL), une autre ligne à retard (FDL) est fournie, appartenant aux moyens d'égalisation de phase (SM, LC, FDL), qui produit une pluralité de phases retardées (FD0, FD1, AD, FD3, FD4) à partir du flux de données d'entrée (DIN).

15. Circuit d'alignement de phase d'un flux de données d'entrée d'une trame à répartition dans le temps, selon la revendication 14, **caractérisé en ce que** les moyens d'égalisation de phase (SM, LC, FDL) comprennent un moyen d'échantillonnage (SM) de ladite pluralité de phases retardées (FD0, FD1, AD, FD3, FD4), qui utilise le signal d'horloge masqué (CKE) comme signal d'horloge.

16. Circuit d'alignement de phase d'un flux de données d'entrée d'une trame à répartition dans le temps, selon la revendication 15, **caractérisé en ce que** ledit moyen d'échantillonnage (SM) de ladite pluralité de phases retardées (FD0, FD1, AD, FD3, FD4) reçoit au moins un deuxième signal d'activation (SEN) généré par les moyens de détection (AFW, ROT), qui indique le transit de la transition dans la séquence de données sûre (AW).

17. Circuit d'alignement de phase d'un flux de données d'entrée d'une trame à répartition dans le temps, selon la revendication 15 ou 16, **caractérisé en ce que** les moyens d'égalisation de phase (SM, LC, FDL) comprennent un moyen logique de commande (LC) agencé en aval du moyen d'échantillonnage (SM), pour recevoir les valeurs échantillonnées de la pluralité de phases retardées (FD0, FD1, AD, FD3, FD4) et émettre les signaux de sélection (SELO, ..., SEL74) en fonction de ceux-ci.

18. Circuit d'alignement de phase d'un flux de données d'entrée d'une trame à répartition dans le temps, selon l'une des revendications 10 à 16, **caractérisé en ce que** la ligne à retard variable (VDL) est obtenue au moyen d'une échelle d'éléments de retard (VDE).

19. Circuit d'alignement de phase selon la revendication 11, dans lequel la ligne à retard (VDL) comprend une pluralité d'éléments de retard (VDE), le flux de données d'entrée (DIN) passant en série à travers ladite pluralité d'éléments de retard (VDE), **caractérisé en ce qu'**un ou plusieurs des éléments de retard (VDE) reçoivent également le flux de données d'entrée (DIN) en parallèle, et **en ce que** lesdits éléments de retard (VDE) sont aptes à sélectionner, parmi les flux de données (DIN) reçus en série ou en parallèle, ceux qui doivent être émis.
